# EUROPEAN PATENT APPLICATION

(11) **EP 3 961 231 A1**
(43) Date of publication of application: **02.03.2022**
(21) Application number: 20790174.5
(22) Date of filing: 31.03.2020
(51) Int. Cl.: G01R 31/34, G01R 31/50, G01R 31/52

(54) **ELECTRIC MACHINE DIAGNOSIS METHOD AND DIAGNOSIS DEVICE, AND ROTATING ELECTRIC MACHINE**

(30) Priority: 26.04.2019 JP 2019085049
(71) Applicant: HITACHI, LTD., Chiyoda-ku Tokyo 100-8280 (JP)
(72) Inventor: YOSHITAKE, Yuuichirou, Tokyo 1008280 (JP); ITO, Yuta, Tokyo 1008280 (JP)
(74) Representative: Mewburn Ellis LLP
(86) International application number: PCT/JP2020/014815
(87) International publication number: WO 2020/217880

(57) **Abstract**

A diagnosis method and a diagnosis device for an electric machine, capable of diagnosing an insulation state of the electric machine with high accuracy, and a rotary electric machine to which these are applied, are disclosed. In the diagnosis method, a ground leakage current of the electric machine is measured temporally continuously during operation of the electric machine, and an insulation deterioration state of the electric machine is determined based on measured values of the ground leakage current including a measured value when the ground leakage current is substantially constant and a measured value when the ground leakage current increases intermittently.

## Description

### Technical Field

The present invention relates to a diagnosis device and a diagnosis method for an electric machine to diagnose an insulation state in a generator, an electric motor, or the like, and a rotary electric machine to which they are applied.

### Background Art

Sudden failures of electric machines such as a generator and an electric motor may lead to unexpected outage of the entire system of the user and greatly affect the social life. In addition, since the Great East Japan Earthquake, there is little room for power supply, and sudden failures of generators at power plants have a great economic and social impact.

The main causes of a failure of an electric machine are mechanical causes related to bearings or the like and electrical causes related to insulation or the like. Sudden failures can be prevented by structurally suppressing occurrence of these causes and by appropriately maintaining the electric machine.

In recent years, technological advances in materials and device structures have allowed electrical machines to be designed in a balanced manner to meet trade-off requirements such as reliability and productivity. However, depending on the surrounding environment and operating conditions, an electrical device may break down. Therefore, in addition to a reliable design, a diagnostic technique that can be easily diagnosed with high accuracy presence or absence of a cause of a failure is becoming more important.

On the other hand, the diagnostic techniques described in PTL 1 and PTL 2 are known.

In the diagnostic technique described in PTL 1, a zero-phase current in three-phase cables connecting an inverter and a load device (such as an electric motor) is measured, and based on the 3rd-order harmonic component and the 3n-order harmonic component extracted from the measured zero-phase current, the insulation resistance value in each phase is calculated.

In the diagnostic technique described in PTL 2, current amplitude resulting from a plurality of deterioration factors can be detected by a current sensor attached to at least two-phase lead wires of a three-phase motor and a current sensor attached to all of the three-phase lead wires collectively.

### Citation List

### Patent Literature

PTL 1: JP 2013-130440 A
PTL 2: JP 2015-215275 A

### Summary of Invention

### Technical Problem

In the above-mentioned diagnostic techniques, the insulation deterioration is determined by using an increase/decrease or a rate of change of the insulation resistance value as an index, or by extracting a difference from the data acquired at the time of soundness. However, the determination criteria and evaluation methods for abnormality are not always fully considered. Therefore, with the above-mentioned diagnostic techniques, it is difficult to detect the insulation state of an electric machine with high accuracy.

Therefore, the present invention provides a diagnosis method and a diagnosis device for an electric machine capable of diagnosing an insulation state of an electric machine with high accuracy, and a rotary electric machine to which these are applied.

### Solution to Problem

In order to solve the above problem, a diagnosis method for an electric machine according to the present invention is a method for diagnosing the insulation state of the electric machine. The method includes measuring a ground leakage current of the electric machine temporally continuously during operation of the electric machine, and determining an insulation deterioration state of the electric machine based on measured values of the ground leakage current including a measured value when the ground leakage current is substantially constant and a measured value when the ground leakage current increases intermittently.

In order to solve the above problem, a diagnosis device for an electric machine according to the present invention is to diagnose the insulation state of the electric machine. The diagnosis device includes a current sensor that detects an electric current flowing through a winding of the electric machine; a current measurement unit that measures a ground leakage current of the electric machine based on a signal of the current sensor; a data recording unit that temporally continuously records measured values of the ground leakage current measured by the current measurement unit; and a data processing unit that determines an insulation deterioration state of the electric machine, based on the measured values of the ground leakage current recorded in the data unit, the measured values including a measured value when the ground leakage current is substantially constant and a measured value when the ground leakage current increases intermittently.

In order to solve the above problem, a rotary electric machine according to the present invention is a machine having windings corresponding to the number of AC phases, and includes a diagnosis device for diagnosing an insulation state of the rotary electric machine. The diagnosis device includes a current sensor that detects an electric current flowing through a winding of the rotary electric machine; a current measurement unit that measures a ground leakage current of the electric machine based on a signal of the current sensor; a data recording unit that temporally continuously records measured values of the ground leakage current measured by the current measurement unit; and a data processing unit that determines an insulation deterioration state of the electric machine, based on the measured values of the ground leakage current recorded in the data recording unit, the measured values including a measured value when the ground leakage current is substantially constant and a measured value when the ground leakage current increases intermittently.

### Advantageous Effects of Invention

According to the present invention, the insulation state of an electric machine can be easily diagnosed with high accuracy.

Issues, configurations and effects other than those described above will be clarified by the description of the embodiments provided below.

### Brief Description of Drawings

[FIG. 1] FIG. 1 is a configuration diagram of a failure diagnosis device for an electric machine according to Exemplary Embodiment 1.
[FIG. 2] FIG. 2 is a partial circuit diagram showing an example of a current sensor that detects an output current of a three-phase AC generator.
[FIG. 3] FIG. 3 is a partial circuit diagram showing an example of a current sensor that detects an output current of a three-phase AC generator.
[FIG. 4] FIG. 4 is a diagram showing an example of temporal changes in the ground leakage current measured during operation of a three-phase AC generator.
[FIG. 5] FIG. 5 is a correlation diagram showing an exemplary relationship between a parameter related to the output of a rotary electric machine and the ground leakage current.
[FIG. 6] FIG. 6 is a correlation diagram showing an exemplary relationship between a parameter related to the output of a rotary electric machine and the ground leakage current.
[FIG. 7] FIG. 7 shows a configuration of a failure diagnosis device for an electric machine according to Exemplary Embodiment 5.

### Description of Embodiments

Hereinafter, embodiments of the present invention will be described with reference to the following Exemplary Embodiments 1 to 5 using the drawings. In the respective drawings, those having the same reference numerals indicate the same constituent requirements or constituent requirements having similar functions.

In each of Exemplary Embodiments 1 to 5, the electric machine is a generator, but these exemplary embodiments can be applied to a rotary electric machine including an electric motor.

### [Exemplary Embodiment 1]

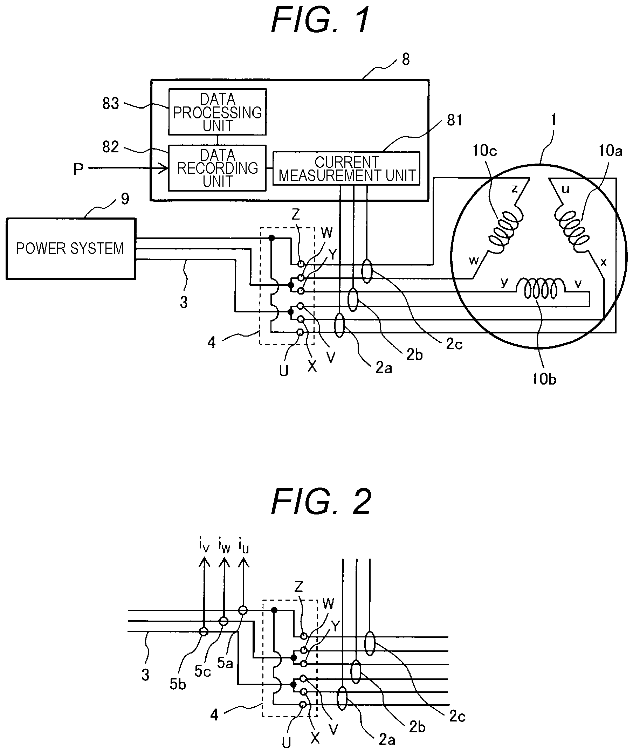

FIG. 1 is a configuration diagram of a failure diagnosis device for an electric machine according to Exemplary Embodiment 1 of the present invention.

The electric machine in the Exemplary Embodiment 1 is a three-phase AC generator 1 connected to a power system 9. As will be described below, in Exemplary Embodiment 1, the leakage current is detected during operation of the three-phase AC generator 1, and based on the detected leakage current, the insulation state of the three-phase AC generator 1 is diagnosed by a measurement system 8.

The three-phase AC generator 1 to be diagnosed has a known configuration. That is, it includes a stator, a rotor facing the stator via a gap of a predetermined dimension, and a case in which the stator and the rotor are housed. The stator includes a magnetic core (not shown) fixed in the case, three-phase windings wound around the magnetic core, namely a U-phase winding 10a in FIG. 1, a V-phase winding 10b, and a W-phase winding 10c, and a main insulating layer that electrically insulates between the magnetic core and the three-phase windings.

A capacitance using the main insulating layer as a dielectric exists between the three-phase windings and the case, and when a voltage is applied to the three-phase windings, a leakage current flows through the capacitance. When the insulation state between the three-phase windings and the case is changed due to deterioration of the main insulating layer or the like, the magnitude of the leakage current changes. In Exemplary Embodiment 1, such a leakage current is detected for each phase by each of current sensors 2a, 2b, and 2c shown in FIG. 1, as will be described later.

A terminal block 4 is provided to the three-phase AC generator 1 to connect cables 3, laid to supply the electric power generated by the three-phase AC generator 1 to the power system 9, to the three-phase AC generator 1. The terminal block 4 includes connection terminals U, X, V, Y, W, and Z. To each of the connection terminals U, X, V, Y, W, Z, lead wires from one end u of the U-phase winding 10a, the other end x of the U-phase winding 10a, one end v of the V-phase winding 10b, the other end y of the V-phase winding 10b, one end w of the W-phase winding 10c, and the other end z of the W-phase winding 10c are electrically connected.

In Exemplary Embodiment 1, the U-phase winding 10a, the V-phase winding 10b, and the W-phase winding 10c are Δ-connected in the terminal block 4. Therefore, in the terminal block 4, the connection terminals U and Z are electrically connected, the connection terminals V and X are electrically connected, and the connection terminals W and Y are electrically connected.

The current sensors 2a, 2b, and 2c are installed on the three-phase AC generator 1 side when viewed from the terminal block 4. For example, the current sensor 2a collectively detects the current flowing through the lead wire from the one end u of the U-phase winding 10a and the current flowing through the lead wire from the other end x of the U-phase winding 10a. Since the current flowing through these lead wires is reciprocating currents, the current sensor 2a detects the difference between the reciprocating currents, that is, the leakage current in the U phase. Similarly, the current sensors 2b and 2c detect the leakage current in the V phase and the leakage current in the W phase, respectively.

With such current sensors 2a, 2b, and 2c, only the leakage current of the respective phases can be detected from the current flowing through the U-phase winding 10a, the V-phase winding 10b, and the W-phase winding 10c. This improves the detection accuracy of the leakage current.

As each of the current sensors 2a, 2b, and 2c, a CT (Current Transformer) or the like is applied.

Here, in Exemplary Embodiment 1, since the case is grounded as in a known generator, the leakage current of each phase flows out to the ground. Therefore, hereinafter, such leakage current will be referred to as "ground leakage current" (the same applies to other exemplary embodiments).

Next, means for diagnosing the insulation state in Exemplary Embodiment 1 will be described.

The measurement system 8 shown in FIG. 1 includes a current measurement unit 81 that measures the ground leakage current of each phase from an output signal of each of the current sensors 2a, 2b, and 2c, a data recording unit 82 that records in time series and accumulates data of the ground leakage current measured by the current measurement unit 81, and a data processing unit 83 that diagnoses the insulation state of the three-phase AC generator 1 based on data such as the ground leakage current accumulated in the data recording unit 82. The current measurement unit 81 creates ground leakage current data in a data format suitable for the operation of the data processing unit 83 and the data recording unit 82, according to an output signal of the current sensor.

Further, the data recording unit 82 records in time series a parameter P related to the output of the three-phase AC generator 1 (for example, a detected value of the output current of the three-phase AC generator 1). The data processing unit 83 of the measurement system 8 in Exemplary Embodiment 1 diagnoses the insulation state of the three-phase AC generator 1 based on the ground leakage current and the parameter P accumulated in the data recording unit 82.

As the current measurement unit 81 and the data recording unit 82, a laptop personal computer with a hard disk (which may also serve as the data processing unit 83), a data logger, an oscilloscope capable of recording data, or the like having those functions can be applied.

As the data processing unit 83, any type of computer or the like can be applied. Note that among the current measurement unit 81, the data recording unit 82, and the data processing unit 83, only the current measurement unit 81 and data recording unit 82 may be installed near the three-phase AC generator 1, and after data of the ground leakage current is accumulated, the data processing unit 83 may be connected to diagnose the insulation state. In that case, it is preferable to use a portable measurement device such as a USB oscilloscope as the current measurement unit 81 and the data recording unit 82.

In Exemplary Embodiment 1, the measurement system 8 (FIG. 1) includes the current measurement unit 81, the data recording unit 82, and the data processing unit 83. These may be separate bodies (for example, a data logger and a personal computer) or may be integrated (for example, a personal computer with a large capacity hard disk). When the current measurement unit 81 and the data recording unit 82 are integrated and the data processing unit 83 is separate from them, the measurement device (for example, data logger) constituting the current measurement unit 81 and the data recording unit 82 may be installed adjacent to the three-phase AC generator 1, and after data is accumulated for a predetermined period, the measurement device may be connected to the computer or the like constituting the data processing unit 83 to diagnose the insulation state.

The measurement system 8 may determine the insulation state based on the data accumulated for a predetermined period, or determine the insulation state while accumulating the ground leakage current data and sequentially acquiring the ground leakage current data. In that case, the data processing unit 83 may acquire the ground leakage current data from the current measurement unit 81 not via the data recording unit 82.

Further, the diagnosis result of the data processing unit 83 may be recorded on the data recording unit 82.

The diagnosis device of Exemplary Embodiment 1 may be provided to a generator to be diagnosed at the time of diagnosis, or may be permanently installed. When it is provided at the time of diagnosis, it is preferable that a current sensor is a clamp type CT that is easily attachable/detachable, but only a current sensor may be permanently installed.

FIG. 2 is a partial circuit diagram showing an example of a current sensor that detects an output current of the three-phase AC generator 1 in the case where the parameter P (FIG. 1) related to the output of the three-phase AC generator 1 recorded in the data recording unit 82 is the output current of the three-phase AC generator 1. Note that this figure shows the vicinity of the terminal block 4 in FIG. 1.

In this example, among the cables 3 for the three phases to connect the terminal block 4 to the power system 9, the cable 3 connected to the connection terminals U and Z, the cable 3 connected to the connection terminals V and X, and the cable 3 connected to the connection terminals W and Y are provided with a current sensor 5a, a current sensor 5b, and a current sensor 5c, respectively. Therefore, the current sensors 5a to 5c are provided on the power system 9 side when viewed from the terminal block 4. The current sensor 5a, the current sensor 5b, and the current sensor 5c detect a U-phase output current i_{U}, a V-phase output current i_{V}, and a W-phase output current i_{W}, respectively, among the output currents of the three-phase AC generator 1.

In this example, the current measurement unit 81 measures the output current of the three-phase AC generator 1 based on the output signals of the current sensors 5a to 5c.

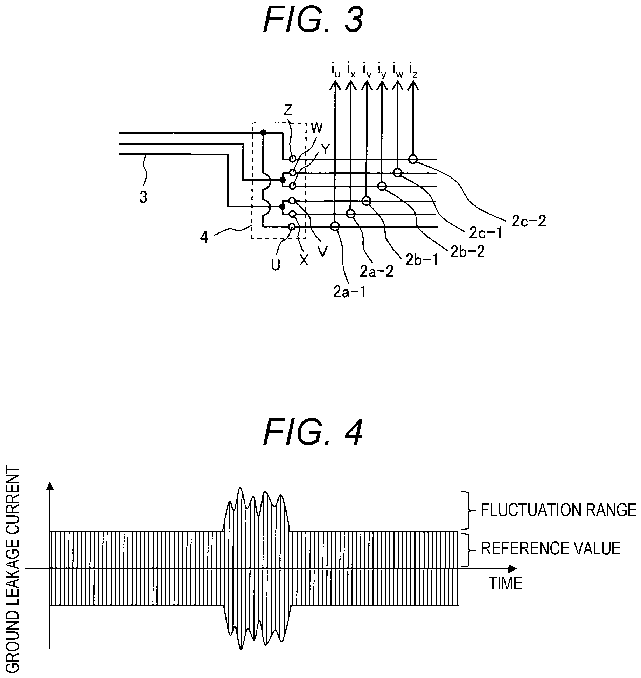

FIG. 3 is a partial circuit diagram showing an example of a current sensor that detects an output current of the three-phase AC generator 1 when the parameter P (FIG. 1) relating to the output of the three-phase AC generator 1 recorded in the data recording unit 82 is the output current of the three-phase AC generator 1. Note that this figure shows the vicinity of the terminal block 4 in FIG. 1.

In this example, a current sensor is provided for each lead wire from the winding of each phase, and the current flowing through each lead wire is detected. That is, as shown in FIG. 3, currents iᵤ, iₓ, iᵥ, i_{y}, i_{w}, and i_{z}, flowing through the lead wires from the one end u of the U-phase winding 10a, the other end x of the U-phase winding 10a, the one end v of the V-phase winding 10b, the other end y of the V-phase winding 10b, the one end w of the W-phase winding 10c, and the other end z of the W-phase winding 10c, are detected by current sensors 2a-1, 2a-2, 2b-1, 2b-2, 2c-1, and 2c-2, respectively.

In this example, the current measurement unit 81 measures the ground leakage current by calculating the difference between the currents flowing through the two lead wires from both ends of the winding of each phase. That is, the current measurement unit 81 measures the ground leakage current in the U phase, the ground leakage current in the V phase, and the ground leakage current in the W phase, by the difference between the current detection values iᵤ and iₓ by the current sensors 2a-1 and 2a-2, the difference between the current detection values iᵥ and i_{y} by the current sensors 2b-1 and 2b-2, and the difference between the current detection values i_{w} and i_{z} by the current sensors 2c-1 and 2c-2, respectively.

The current measurement unit 81 measures the U-phase output current of the three-phase AC generator 1 based on the current detection values iᵤ and i_{z} by the current sensors 2a-1 and 2c-2. Further, the current measurement unit 81 measures the V-phase output current of the three-phase AC generator 1 based on the current detection values iₓ and iᵥ of the current sensors 2a-2 and 2b-1, and measures the W-phase output current of the three-phase AC generator 1 based on the current detection values i_{y} and i_{w} by the current sensors 2b-2 and 2c-1.

In this example, restrictions on the mounting locations of the current sensor, due to the connection states between the lead wires and the connection terminals U, X, V, Y, W, Z of the terminal block 4 and the laying state of the lead wires, are reduced.

Hereinafter, means for determining the insulation deterioration in the electric machine in Exemplary Embodiment 1 will be described.

FIG. 4 is a diagram showing an example of a temporal change in the ground leakage current measured during operation of the three-phase AC generator.

As shown in FIG. 4, the ground leakage current is increasing intermittently. According to the study by the present inventor, when the operation of the rotary electric machine changes from the low output region to the high output region and the output increases, the ground leakage current suddenly increases. According to the study by the present inventor, this is due to the fact that the mechanical force (vibration or electromagnetic vibration) applied to the insulating layer increases in the high output region.

Here, as shown in FIG. 4, the value of the ground leakage current with relatively little fluctuation in the low output region, that is, the amplitude of the ground leakage current when there is no substantial fluctuation, is referred to as a "reference value" and the amount of increase from the reference value is referred to as a "fluctuation range".

According to the study by the present inventor, in a rotary electric machine in which insulation deterioration has progressed, the fluctuation range of the ground leakage current tends to be larger than that in the initial state. This is because, according to the study by the present inventor, as the insulation deterioration progresses, the influence of the mechanical force applied to the insulating layer on the ground leakage current becomes larger.

Therefore, the degree of insulation deterioration can be quantitatively determined by measuring the fluctuation range of the ground leakage current in the initial state and in the aged state of the three-phase AC generator.

Therefore, in Exemplary Embodiment 1, the data recording unit 82 (FIG. 1) temporally continuously records the measured values of the ground leakage current by the current measurement unit 81 (FIG. 1). Then, the data processing unit 83 (FIG. 1) determines the insulation deterioration state of the three-phase AC generator 1, based on the measured values recorded in the data recording unit 82, that is, the measured values of the ground leakage current including a measured value when the ground leakage current is substantially constant (reference value) and a measured value when the ground leakage current increases intermittently, as shown in FIG. 4.

In Exemplary Embodiment 1, the data processing unit 83 calculates the above-mentioned fluctuation range from the measured value of the ground leakage current, compares it with the fluctuation range in the initial state, which is measured in advance and set in the measurement system 8, and determines the insulation deterioration state (degree of progress of insulation deterioration, or the like) of the three-phase AC generator 1 based on the comparison result. The data processing unit 83 may determine whether or not the calculated fluctuation range exceeds an allowable value, and if it exceeds the allowable value, it may determine that the insulation state of the three-phase AC generator 1 is abnormal. The allowable value of the fluctuation width may be set in advance in the measurement system 8, or calculated by the data processing unit 83 from the fluctuation range in the initial state and a predetermined allowable increase rate.

When the value of the parameter P (FIG. 1:, for example, the output current) recorded in the data recording unit 82, among the measured values of the ground leakage current recorded in the data recording unit 82, is equal to or larger than a present value and indicates high output operation, the data processing unit 83 may calculate the corresponding fluctuation range, that is, the fluctuation range of the measured value of the ground leakage current recorded at the same time as the parameter P is calculated, and determine the insulation state of the three-phase AC generator 1 based on the calculated fluctuation range. As a result, the insulation state of the three-phase AC generator 1 can be reliably determined.

According to Exemplary Embodiment 1, as described above, the ground leakage current is measured temporally continuously during the operation of the three-phase AC generator, and based on the measured values of the ground leakage current including the measured value (reference value) when the ground leakage current is substantially constant and the measured value when the ground leakage current increases intermittently, the insulation deterioration state of the three-phase AC generator is determined. Therefore, the insulation state of the three-phase AC generator can be diagnosed with high accuracy and easily. In addition, since the insulation state of the three-phase AC generator is diagnosed based on the fluctuation range of the measured value of the ground leakage current when the output of the three-phase AC generator increases, that is, an increment from the reference value, the insulation deterioration state of the three-phase AC generator can be reliably determined.

The insulation state diagnosis means of Exemplary Embodiment 1 is applicable not only to a three-phase AC generator but also to a rotary electric machine such as a three-phase AC electric motor (the same applies to each of the exemplary embodiments described later).

### [Exemplary Embodiment 2]

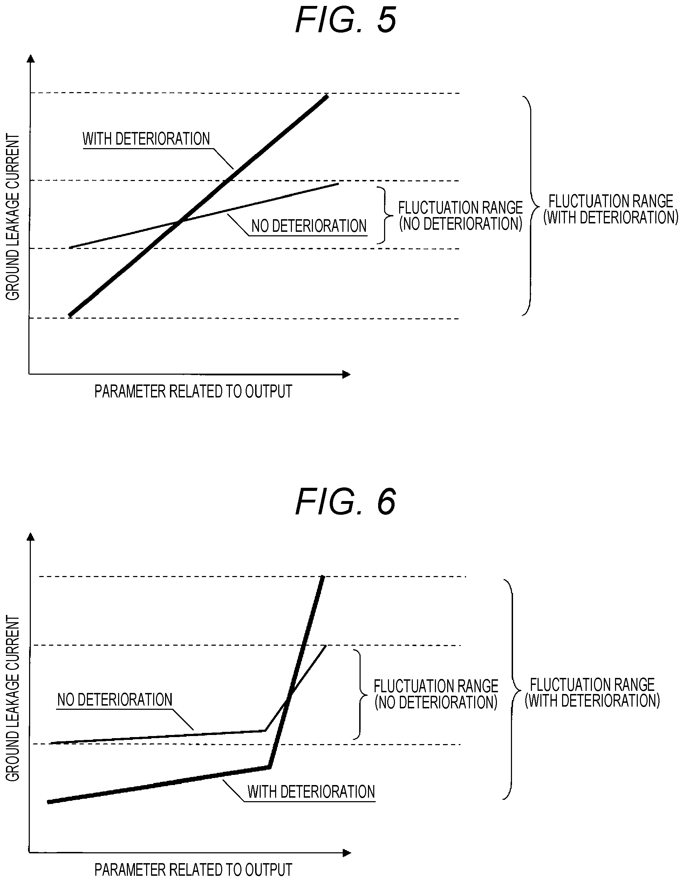

Next, a failure diagnosis device for an electric machine according to Exemplary Embodiment 2 of the present invention will be described with reference to FIG. 5.

The device configuration of Exemplary Embodiment 2 is the same as that of Exemplary Embodiment 1 (FIG. 1). Further, operations of the current measurement unit 81 and the data recording unit 82 in Exemplary Embodiment 2 are the same as those in Exemplary Embodiment 1.

Hereinafter, the points different from those of Exemplary Embodiment 1, that is, mainly means for determining insulation deterioration, will be described.

FIG. 5 is a correlation diagram showing an exemplary relationship between a parameter related to the output of a rotary electric machine and the ground leakage current. This correlation diagram is a result of a study by the present inventor. Here, parameters related to the output of the rotary electric machine include a load current, an output current, a power generation amount, wind speed (in the case of a wind power generator), and the like.

In FIG. 5, the vertical axis shows the ground leakage current and the horizontal axis shows a parameter related to the output. However, the values of the parameter related to the output of the rotary electric machine and the ground leakage current in FIG. 5 are average values calculated by averaging measured values of the ground leakage current and a parameter related to the output during operation of the rotary electric machine for a relatively short predetermined time width (in the case of FIG. 5, every 1 minute).

As shown in FIG. 5, within a predetermined range of the parameter related to the output, the ground leakage current changes linearly in proportion to the parameter related to the output. Here, the predetermined range of a parameter corresponds to the operation region extending from the low output region to the high output region described above in Exemplary Embodiment 1 (the same applies to Exemplary Embodiment 3 described later). The inclination of the straight line showing the correlation between the parameter related to the output and the ground leakage current is larger in a rotary electric machine having insulation deterioration as in the aged state than in a rotary electric machine having no insulation deterioration as in the initial state. Therefore, the difference between the maximum value and the minimum value of the ground leakage current in FIG. 4, that is, the fluctuation range of the ground leakage current, is larger in a rotary electric machine having insulation deterioration than in a rotary electric machine having no insulation deterioration.

In this way, the correlation between the ground leakage current and a parameter related to the output is obtained from the measured values of the ground leakage current and the parameter related to the output during operation of the rotary electric machine, and based on the obtained correlation, the insulation deterioration state of the rotary electric machine can be quantitatively determined.

Therefore, in Exemplary Embodiment 2, the data processing unit 83 included in the measurement system 8 (FIG. 1) obtains the correlation as described above from the measured values of the parameter P (for example, output current) and the ground leakage current recorded in the data recording unit 82.

In the measurement system 8, the correlation between the ground leakage current and the parameter related to the output in the initial state of the three-phase AC generator 1 is set in advance, and the data processing unit 83 compares the correlation in the initial state with the correlation in the aged state, and based on the inclination of the straight line and the fluctuation range indicating the correlation, determines the insulation deterioration state. In addition, threshold values for the allowable inclination of the straight line and the fluctuation range may be set in advance in the measurement system 8, and when the inclination of the straight line and the fluctuation width in the obtained correlation exceed the threshold values, it may be determined that the insulation state is abnormal.

According to Exemplary Embodiment 2, as in Exemplary Embodiment 1, the insulation state of the three-phase AC generator can be diagnosed with high accuracy and easily, and the insulation deterioration state of the three-phase AC generator can be reliably determined.

### [Exemplary Embodiment 3]

Next, a failure diagnosis device for an electric machine according to Exemplary Embodiment 3 of the present invention will be described with reference to FIG. 6.

The device configuration of Exemplary Embodiment 3 is the same as that of Exemplary Embodiment 1 (FIG. 1). Further, operations of the current measurement unit 81 and the data recording unit 82 in Exemplary Embodiment 3 are the same as those in Exemplary Embodiment 1.

Hereinafter, the points different from those of Exemplary Embodiment 1, that is, mainly means for determining insulation deterioration, will be described.

FIG. 6 is a correlation diagram showing an exemplary relationship between a parameter related to the output of a rotary electric machine and the ground leakage current. This correlation diagram is a result of a study by the present inventor. Here, parameters related to the output of the rotary electric machine include a load current, an output current, a power generation amount, wind speed (in the case of a wind power generator), and the like.

In FIG. 6, the vertical axis shows the ground leakage current and the horizontal axis shows a parameter related to the output. However, the values of the parameter related to the output of the rotary electric machine and the ground leakage current in FIG. 6 are average values calculated by averaging measured values of the ground leakage current and the parameter related to the output during operation of the rotary electric machine for a predetermined time width longer than that of the example in FIG. 5 (in the case of FIG. 6, every 10 minutes).

As shown in FIG. 6, within a predetermined range of a parameter related to the output, the ground leakage current changes linearly in proportion to the parameter related to the output in a region where the output is relatively small. The inclination of the straight line showing the correlation between the parameter related to the output and the ground leakage current is gentle, and the ground leakage current has a substantially constant value.

Further, as shown in FIG. 6, in a predetermined range of the parameter related to the output, the ground leakage current is in proportion to the parameter related to the output in the region where the output is relatively large, and changes linearly. The inclination of the straight line showing the correlation between the parameter related to the output and the ground leakage current is larger than that in the low output region, and the ground leakage current changes significantly.

In the region where the output is relatively large, the inclination of the straight line showing the correlation between the parameter related to the output and the ground leakage current is larger in a rotary electric machine having insulation deterioration as in the aged state, than that in a rotary electric machine having no insulation deterioration as in the initial state. Therefore, the difference between the maximum value and the minimum value (= constant value in the low output region) of the ground leakage current in FIG. 6, that is, the fluctuation range of the ground leakage current, is larger in the rotary electric machine having insulation deterioration than that in the rotary electric machine having no insulation deterioration.

Similar to the example of FIG. 5, the correlation between the ground leakage current and a parameter related to the output is obtained from the measured values of the ground leakage current and the parameter related to the output during operation of the rotary electric machine, and based on the obtained correlation, the insulation deterioration state of the rotary electric machine can be quantitatively determined.

Therefore, in Exemplary Embodiment 3, the data processing unit 83 included in the measurement system 8 (FIG. 1) obtains the correlation as described above from the measured values of the parameter P (for example, output current) and the ground leakage current recorded in the data recording unit 82.

Similar to Exemplary Embodiment 2, the data processing unit 83 compares the correlation in the initial state with the correlation in the aged state, and determines the insulation deterioration state based on the inclination of the straight line and the fluctuation range indicating the correlation. Further, as in Exemplary Embodiment 2, the data processing unit 83 may determine that the insulation state is abnormal when the inclination of the straight line or the fluctuation range in the obtained correlation exceeds a threshold value.

According to Exemplary Embodiment 3, as in Exemplary Embodiments 1 and 2, the insulation state of the three-phase AC generator can be diagnosed with high accuracy and easily, and the insulation deterioration state of the three-phase AC generator can be reliably determined.

### [Exemplary Embodiment 4]

Next, a failure diagnosis device for an electric machine according to Exemplary Embodiment 4 of the present invention will be described with reference to FIGS. 4 to 6.

The device configuration of Exemplary Embodiment 4 is the same as that of Exemplary Embodiment 1 (FIG. 1). Further, operations of the current measurement unit 81 and the data recording unit 82 in Exemplary Embodiment 4 are the same as those in Exemplary Embodiment 1.

Hereinafter, the points different from those of Exemplary Embodiments 1 to 3, that is, mainly means for determining insulation deterioration, will be described.

In Exemplary Embodiment 4, the data processing unit 83 (FIG. 1) quantitatively evaluates the insulation deterioration of a three-phase AC generator based on the reference value of the ground leakage current as shown in FIG. 4 or a minimum value of the ground leakage current in a predetermined range of a parameter related to the output as shown in FIGS. 5 and 6.

Here, according to the study by the present inventor, the reference value and the minimum value of the ground leakage current correlate with the capacitance of the rotary electric machine. The capacitance of the rotary electric machine exists between the winding and the case, with an insulating layer that electrically insulates between the magnetic core and the winding being a dielectric.

According to the study by the present inventor, when thermal deterioration or void generation progresses in the insulating layer, the capacitance becomes smaller than that of the initial state, and the reference value and the minimum value of the ground leakage current become smaller than those in the initial state. Further, when moisture absorption deterioration occurs in the insulating layer, the capacitance becomes larger than that of the initial state, and the reference value and the minimum value of the ground leakage current become larger than that in the initial state.

Therefore, the degree of insulation deterioration can be quantitatively determined by measuring the ground leakage current during operation of the rotary electric machine, detecting the reference value or the minimum value of the ground leakage current, and comparing it with the reference value or the minimum value of the ground leakage current in the initial state detected in advance. In addition, it is also possible to set the upper limit value and the lower limit value in advance to the reference value or the minimum value of the allowable ground leakage current, and when the upper limit value is exceeded or the lower limit value is exceeded, the insulation state may be determined to be abnormal.

Therefore, in Exemplary Embodiment 4, the data processing unit 83 included in the measurement system 8 (FIG. 1) extracts the reference value of the ground leakage current (FIG. 4) as described above from the measured values of the parameter P (for example, output current) and the ground leakage current recorded in the data recording unit 82, or extracts the minimum value of the ground leakage current in the correlation (FIGS. 5 and 6) as described above. The data processing unit 83 compares the extracted reference value or the minimum value with the initial value set in advance in the measurement system (reference value or minimum value in the initial state of the three-phase AC generator), and based on the comparison result, quantitatively evaluates the degree of insulation deterioration of the three-phase AC generator. Further, the data processing unit 83 may determine that the insulation state is abnormal when the measured value exceeds or falls below the threshold of the allowable reference value or the minimum value set in the measurement system 8 in advance.

In the correlation shown in FIG. 6, a substantially constant value of the ground leakage current in the region where the ground leakage current changes gently may be set as a minimum value with respect to the parameter related to the output.

According to Exemplary Embodiment 4, the insulation state of the three-phase AC generator can be diagnosed with high accuracy and easily, and the insulation deterioration state of the three-phase AC generator can be reliably determined.

### [Exemplary Embodiment 5]

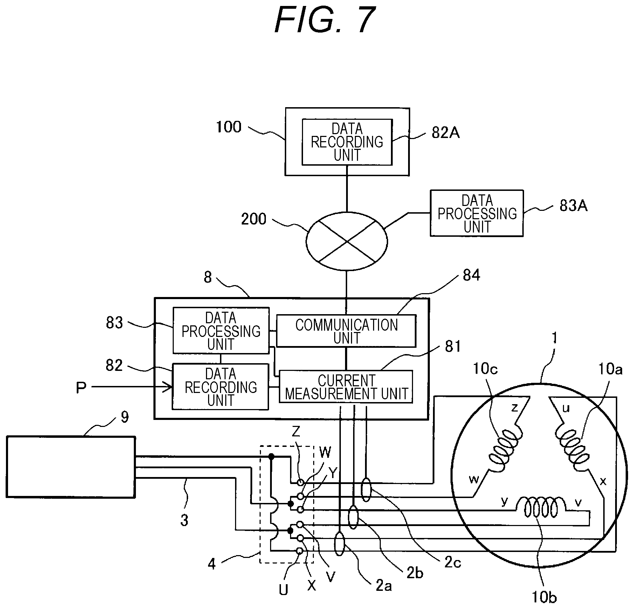

Next, a failure diagnosis device for an electric machine according to Exemplary Embodiment 5 of the present invention will be described with reference to FIG. 7. Note that in Exemplary Embodiment 5, an insulation state evaluation means in any of the above-mentioned Exemplary Embodiments 1 to 4 is applied.

FIG. 7 shows the configuration of a failure diagnosis device for an electric machine according to Exemplary Embodiment 5 of the present invention. Hereinafter, the differences from Exemplary Embodiment 1 will be described mainly with respect to the device configuration.

As shown in FIG. 7, the measurement system 8 in Exemplary Embodiment 5 includes a communication unit 84 that transmits measured data to the outside, in addition to the current measurement unit 81, the data recording unit 82, and the data processing unit 83.

The measured data of the parameter P related to the output of the three-phase AC generator 1 and the measured data of the ground leakage current output by the current measurement unit 81 are transmitted to a data center server 100 located geographically distant from the installation location of the three-phase AC generator 1, by the communication unit 84 via a communication network 200. The communication network 200 may be either wireless or wired.

The data center server 100 includes a data recording unit 82A. Each measured data received from the measurement system 8 on the generator side is recorded and accumulated in the data recording unit 82A. As a result, a huge amount of measured data, measured in the operating state of the three-phase AC generator 1, can be recorded and accumulated. The data center server 100 receives measured data transmitted from a plurality of generator sides including other generators not shown, and records it in the data recording unit 82A.

The communication unit 84 may sequentially transmit each piece of measured data to the data center server 100, or transmit the measured data, accumulated in the data recording unit 82 on the generator side in a predetermined time period, to the data center server 100 periodically (for example, at the same time interval as the data storage period).

The insulation state diagnosis result by the data processing unit 83 may be transmitted to the data center server 100 by the communication unit 84.

Further, when the data processing unit 83 on the generator side sequentially executes diagnosis of the insulation state and determines that the insulation state is abnormal, the communication unit 84 may issue an alarm to the data center server 100 via the communication network 200. In that case, at the point of time when the data processing unit 83 determines that the insulation state is abnormal, the communication unit 84 transmits the measured data accumulated in the data recording unit 82 to the data center server 100 for detailed analysis of the insulation state.

In Exemplary Embodiment 5, the data recording unit 82A included in the data center server 100 is a main data recording unit, and the data recording unit 82 included in the measurement system 8 on the generator side is for backing up data. By appropriately setting the amount of data to be backed up and the backup period, the data recording capacity of the data recording unit 82 included in the measurement system 8 on the generator side can be reduced. In that case, the data recording capacity of the data recording unit 82 is smaller than the data recording capacity of the measured data from the measurement system 8 in the data recording unit 82A. It is also possible that the data recording unit 82 is not provided on the generator side.

A data processing unit 83A, which is located geographically distant from the installation location of the three-phase AC generator 1, acquires the measured data accumulated in the data recording unit 82A via the communication network 200, and based on the measured data, diagnoses the insulation state of the three-phase AC generator 1.

The data processing unit 83A may be provided to the data center server 100. In that case, the data processing unit 83A acquires the measured data from the data recording unit 82A not via the communication network 200. In addition, the data processing unit 83 included in the measurement system 8 on the generator side may acquire the measured data accumulated in the data recording unit 82A via the communication network 200, and based on the acquired measured data, diagnose the insulation state of the three-phase AC generator 1.

As described above, according to Exemplary Embodiment 5, the measurement system 8 includes the communication unit 84 that sends the measured data to the communication network, so that the measured data can be recorded in the large-capacity data recording unit 82A of the data center server 100. Therefore, a huge amount of measured data can be accumulated and used for diagnosis of insulation state and detailed analysis.

Note that the present invention is not limited to the above-described exemplary embodiments, but includes various modifications. For example, the above-described exemplary embodiments are described in detail to explain the present invention in an easy-to-understand manner, and are not necessarily limited to those having all the described configurations. Moreover, it is possible to add, delete, and replace other configurations for part of the configurations of the respective exemplary embodiments.

For example, the above-mentioned insulation state diagnosis means can be applied not only to a generator but also to various rotary electric machines including an electric motor. Further, the above-mentioned insulation state diagnosis means can be applied to a linear synchronous motor or a linear induction motor having three-phase armature windings. In the case of an electric motor, various AC power supply devices may be applied instead of the power system 9. Further, in the case of an electric motor, for example, a load current is used as the parameter P related to the output.

Further, the number of AC phases of an electric machine is not limited to three but may be a plurality of phases.

Further, the target for diagnosing the insulation state may be a rotary electric machine having a rated voltage of 700 V or less. In that case, since partial discharge deterioration is unlikely to occur, insulation deterioration due to thermal deterioration, moisture absorption deterioration, or the like can be accurately diagnosed.

Further, the initial value of the capacitance used for the diagnosis may be calculated by using the design information acquired from the existing stator winding drawing or the like.

### Reference Signs List

- 1: three-phase AC generator
- 2a, 2b, 2c: current sensor
- 2a-1, 2a-2, 2b-1, 2b-2, 2c-1, 2c-2: current sensor
- 3: cable
- 4: terminal block
- 8: measurement system
- 9: power system
- 10a: U-phase winding
- 10b: V-phase winding
- 10c: W-phase winding
- 81: current measurement unit
- 82, 82A: data recording unit
- 83, 83A: data processing unit
- 84: communication unit
- 100: data center server
- 200: communication network

## Claims

1. A diagnosis method for an electric machine to diagnose an insulation state of the electric machine, the method comprising:
measuring a ground leakage current of the electric machine temporally continuously during operation of the electric machine; and
determining an insulation deterioration state of the electric machine, based on measured values of the ground leakage current including a measured value when the ground leakage current is substantially constant and a measured value when the ground leakage current increases intermittently.

2. The diagnosis method for the electric machine according to claim 1, wherein the measured value when the ground leakage current increases intermittently is a measured value when output of the electric machine increases.

3. The diagnosis method for the electric machine according to claim 1, comprising
determining the insulation deterioration state of the electric machine, based on a fluctuation range of the measured value when the ground leakage current increases intermittently from the measured value when the ground leakage current is substantially constant.

4. The diagnosis method for the electric machine according to claim 1, comprising
determining the insulation deterioration state of the electric machine, based on the measured value when the ground leakage current is substantially constant.

5. The diagnosis method for the electric machine according to claim 1, comprising
determining the insulation deterioration state of the electric machine, based on a correlation between the measured values of the ground leakage current and a parameter related to the output of the electric machine.

6. The diagnosis method for the electric machine according to claim 5, comprising:
determining the insulation deterioration state of the electric machine, based on a difference between a maximum value and a minimum value of the ground leakage current in the correlation.

7. The diagnosis method for the electric machine according to claim 5, comprising
determining the insulation deterioration state of the electric machine, based on an inclination of a straight line representing the correlation.

8. The diagnosis method for the electric machine according to claim 5, comprising:
determining the insulation deterioration state of the electric machine, based on a minimum value of the ground leakage current in the correlation.

9. The diagnosis method for the electric machine according to claim 5, comprising:
determining the insulation deterioration state of the electric machine, based on a value of the ground leakage current in a region where the ground leakage current is substantially constant with respect to the parameter, in the correlation.

10. A diagnosis device for an electric machine, the diagnosis device diagnosing an insulation state of the electric machine, the device comprising:
a current sensor that detects an electric current flowing through a winding of the electric machine;
a current measurement unit that measures a ground leakage current of the electric machine based on a signal of the current sensor;
a data recording unit that temporally continuously records measured values of the ground leakage current measured by the current measurement unit; and
a data processing unit that determines an insulation deterioration state of the electric machine, based on the measured values of the ground leakage current recorded in the data recording unit, the measured values including a measured value when the ground leakage current is substantially constant and a measured value when the ground leakage current increases intermittently.

11. The diagnosis device for the electric machine according to claim 10, wherein the data processing unit determines the insulation deterioration state of the electric machine, based on a fluctuation range of the measured value when the ground leakage current increases intermittently from the measured value when the ground leakage current is substantially constant.

12. The diagnosis device for the electric machine according to claim 10, wherein the data processing unit determines the insulation deterioration state of the electric machine, based on the measured value when the ground leakage current is substantially constant.

13. The diagnosis device for the electric machine according to claim 10, wherein
the data recording unit records a parameter related to output of the electric machine, and
the data processing unit determines the insulation deterioration state of the electric machine, based on a correlation between the measured values of the ground leakage current and the parameter.

14. The diagnosis device for the electric machine according to claim 10, comprising:
a communication unit that sends data of the ground leakage current measured by the current measurement unit to a communication network, wherein
the data recording unit records the data of the ground leakage current sent from the communication unit via the communication network.

15. A rotary electric machine having wirings for a number of AC phases, the machine comprising a diagnosis device that diagnoses an insulation state of the rotary electric machine, wherein
the diagnosis device includes:
a current sensor that detects an electric current flowing through the windings of the rotary electric machine;
a current measurement unit that measures a ground leakage current of the rotary electric machine based on a signal of the current sensor;
a data recording unit that temporally continuously records measured values of the ground leakage current measured by the current measurement unit; and
a data processing unit that determines an insulation deterioration state of the rotary electric machine, based on the measured values of the ground leakage current recorded in the data recording unit, the measured values including a measured value when the ground leakage current is substantially constant and a measured value when the ground leakage current increases intermittently.
